# DEMANDE DE BREVET EUROPEEN

(11) **EP 4 183 492 A1**
(43) Date de publication de la demande: **24.05.2023**
(21) Numéro de dépôt: 22207971.7
(22) Date de dépôt: 17.11.2022
(51) Int. Cl.: B08B 1/00, B08B 9/027, B08B 15/04, B08B 5/04, A46B 13/00, A46B 13/02, B08B 1/04, B08B 9/043, B08B 9/045, B08B 9/08, C23C 16/44

(54) **DISPOSITIF DE NETTOYAGE DU TUBE QUARTZ D'UN FOUR LPCVD**

(30) Priorité: 23.11.2021 FR 2112379
(71) Demandeur: Commissariat à l'énergie atomique et aux énergies alternatives, 75015 Paris (FR)
(72) Inventeur: VACHEZ, Alexandre, 38054 Grenoble cedex 09 (FR); SOUCHE, Florent, 38054 Grenoble cedex 09 (FR)
(74) Mandataire: Cabinet Nony

(57) **Abrégé**

L'invention concerne un dispositif de nettoyage (50) du tube quartz (30) d'un four LPCVD (10) comportant :
- un support (52),
- une brosse (54) montée sur le support (52) comportant :
o une âme (55),
o une pluralité d'éléments flexibles (56) de nettoyage s'étendant de l'âme (55) de longueur, prise d'un axe longitudinal de l'âme (55) à leur extrémité distale, supérieure ou égale au rayon interne du tube quartz (30) du four LPCVD, et

- un système d'aspiration (70) configuré pour aspirer vers l'extérieur du tube quartz des particules détachées de la paroi du tube quartz par la brosse durant le nettoyage.

## Description

La présente invention concerne un dispositif de nettoyage du tube quartz d'un four de dépôt chimique en phase vapeur (four LPCVD) et un ensemble d'un four LPCVD comportant un tube quartz et du dispositif de nettoyage du tube quartz associé. Elle concerne également un procédé de nettoyage correspondant.

### Technique antérieure

Les fours LPCVD comportent dans une cavité un tube quartz cylindrique formant l'enceinte de traitement du four. L'enceinte est ouverte à une de ses extrémités pour être équipée de façon amovible de cannes d'injection des gaz, de nacelles de support sur lesquelles les objets à traiter sont posés. Elle est fermée par une flasque d'extrémité amovible. Lors de l'utilisation de tels fours LPCVD, des dépôts successifs de silicium se forment à la surface interne du tube quartz. Avec le temps, les dépôts successifs de silicium se délaminent et forment des particules plus ou moins grosses qui dégradent les traitements suivants. Il est donc nécessaire de nettoyer régulièrement le tube quartz pour en retirer les dépôts successifs pour en augmenter la durée de vie.Actuellement, le nettoyage du tube quartz se fait hors de la cavité du four par un procédé de nettoyage chimique. Un tel nettoyage nécessite l'extraction du four du tube quartz avec un risque important de casse du tube quartz, notamment du fait des contraintes mécaniques générées par les dépôts successifs de silicium sur le tube quartz.

Il est connu du brevet US5535471, un dispositif de nettoyage de l'intérieur d'un tube, notamment de l'intérieur d'un tube quartz de four LPCVD, comportant un tube creux présentant à son extrémité distale une plaque de raclage des parois cylindrique de diamètre sensiblement identique à celle du four. La partie creuse du tube creux est reliée en partie proximale à un système d'aspiration et s'ouvre en partie distale en aval de la plaque de raclage pour aspirer les particules de la paroi interne du tube quartz décollées par la plaque de raclage. Une telle plaque de raclage doit s'ajuster précisément dans le tube quartz à nettoyer, ce qui la rend compliquée à fabriquer ; la moindre erreur d'ajustement pouvant endommager le tube quartz. De plus, il génère des contraintes importantes sur le tube quartz, ce qui peut entrainer une casse de ce dernier. Enfin, dans le cas où le tube quartz présente des défauts de sa surface intérieure, un tel dispositif de nettoyage ne permet pas un nettoyage efficace, des défauts en saillie empêchant l'utilisation du dispositif de nettoyage sans casse du tube quartz et des défauts en retrait ne pouvant pas être nettoyé efficacement.

Il est connu des dispositifs de nettoyage de tube de chaudière du brevet US2193999. Un tel dispositif comporte une brosse associée à un racleur en arrière de la brosse. Il est connu du brevet US5109562 un dispositif de nettoyage de tube LPCVD par racleur ou brosse simple, le tout associé à un système d'aspiration passant par l'âme de du dispositif. De tels dispositif avec racleur présentent les problématiques évoquées ci-dessus.

La demande de brevet US20170258214 décrit une brosse de nettoyage de tube ou d'application de cosmétique ayant une portion ronde en extrémité ou entre deux portions de brosse formée par des brins dans une âme formée de deux brins torsadés.

La demande de brevet EP 2 647 442 décrit un dispositif de nettoyage de trou de perçage comportant une cloche d'aspiration configurée pour se mettre contre une paroi et une brosse s'étendant de la cloche et reliée à un moteur rotatif. L'application et les contraintes de ce genre d'application sont bien différentes de celles des fours LPCVD.

La demande de brevet US 20030192143 décrit un dispositif de nettoyage relié à un tube flexible comportant une brosse reliée à une source d'aspiration.Il existe donc un besoin d'un dispositif de nettoyage des tubes quartz des fours LPCVD ne nécessitant pas l'extraction du tube quartz hors du four LPCVD qui soit à la fois efficace et qui génère peu de contraintes sur le tube quartz afin de limiter les risques de casse de ce dernier.

### Exposé de l'invention

L'invention répond à ce besoin, selon un premier aspect, à l'aide d'un dispositif de nettoyage du tube quartz d'un four de dépôt chimique en phase vapeur (LPCVD) comportant :
- un support,
- une brosse montée sur le support comportant :
   o une âme,
   o une pluralité d'éléments flexibles de nettoyage s'étendant de l'âme de longueur, prise d'un axe longitudinal de l'âme à leur extrémité distale, supérieure ou égale au rayon interne du tube quartz du four LPCVD, et
- un système d'aspiration configuré pour aspirer vers l'extérieur du tube quartz des particules détachées du tube quartz par la brosse durant le nettoyage.

Avec un tel dispositif, le nettoyage du tube quartz peut être réalisé sans extraire le tube quartz du four. Il suffit de retirer la ou les parties mobiles de l'équipement du four, composées notamment des nacelles, du flasque d'extrémité et des cannes d'injections des gaz et d'insérer le support et la brosse dans le four LPCD de sorte que l'âme de la brosse s'étende selon l'axe longitudinal du tube quartz. Lors du nettoyage avec ce dispositif, les éléments flexibles viennent en contact de la paroi intérieur du tube quartz du fait de leur longueur et décollent, par frottement, des particules de silicium de la paroi interne du tube quartz. Ces dernières sont évacuées par le système d'aspiration.

L'utilisation d'une brosse permet d'avoir à la fois un nettoyage efficace par frottement, de préférence répétitif, des éléments flexibles sur la paroi interne du tube quartz, et exerçant peu de contraintes sur le tube quartz. Le mouvement répétitif de la brosse dans le four peut être réalisé manuellement ou de façon automatique, notamment à l'aide d'un moteur linéaire ou rotatif.

De préférence, le dispositif, notamment le support, est allongé le long d'un axe longitudinal. Ceci permet de faciliter le nettoyage du tube qui est lui-même allongé.

Le dispositif peut comporter une extrémité distale configurée pour s'insérer dans le tube du four lors du nettoyage et une extrémité proximale, notamment configurée pour être externe au tube du four durant le nettoyage.

De préférence, la longueur des éléments flexibles est strictement supérieure au rayon interne du tube.

De préférence, la longueur des éléments flexibles, prise de l'âme à leur extrémité distale, est inférieure ou égale à 130%, de préférence inférieure ou égale à 105 % du rayon interne du tube quartz.

De préférence, la brosse présente une surface enveloppe cylindrique de révolution. De préférence, La brosse présente une surface enveloppe de diamètre supérieur ou égal au diamètre interne du tube. Le diamètre de la surface enveloppe de la brosse peut être inférieur ou égal à 130%, de préférence inférieur ou égal à 105% du diamètre interne du tube. De préférence, le diamètre de la surface enveloppe de la brosse est supérieur ou égal, de préférence strictement supérieur, au diamètre interne du tube. De préférence, l'âme de la brosse est sensiblement centrale par rapport à la surface enveloppe de la brosse.

L'âme peut comporter deux brins torsadés, les éléments flexibles s'étendant entre les deux brins. Les deux brins peuvent être métalliques. En variante, l'âme est moulée, les éléments flexibles s'étendant de la surface de l'âme, notamment étant moulés avec l'âme.

De préférence, l'âme présente une partie d'extrémité proximale dépourvue d'élément flexible et configurée pour être montée sur le support et une partie de brossage portant les éléments flexibles.

De préférence, les éléments flexibles sont en un matériau choisi parmi le téflon ou le plastique, notamment en nylon ou en polyfluorure de vinylidène (PVDF)

Les éléments flexibles peuvent être des bandes de section rectangulaire. Ils peuvent être de largeur comprise entre 3 mm et 5 mm et/ou d'épaisseur comprise entre 3 mm et 5 mm.

De préférence, la brosse, notamment la partie de brossage, présente une longueur inférieure ou égale à la longueur du tube du four, mieux inférieure ou égale à 50% de la longueur du tube du four, encore mieux inférieure ou égale à 30% de la longueur du tube du four. La brosse, notamment la partie de brossage, peut présenter une longueur supérieure ou égale à 5 cm , mieux supérieure ou égale à 8 cm.

De préférence, la brosse est montée mobile en translation et/ou en rotation relativement au support. En variante, la brosse est montée fixe relativement au support.

De préférence, le dispositif comporte un moteur rotatif relié à la brosse et/ou le support pour entrainer la brosse et/ou le support en rotation.

Le dispositif, notamment le support, comporte une structure de maintien de la brosse en amont des éléments flexibles, notamment entre le moteur et les éléments flexibles. Une telle structure permet de maintenir les éléments flexibles en contact de la paroi intérieure du tube quartz durant l'insertion de la brosse dans le tube quartz.

De préférence, la structure de maintien est rigide.

De préférence, l'âme de la brosse est centrale par rapport à la structure de maintien.

De préférence, la structure de maintien est fixe par rapport au support, notamment est fixée au support ou venue de matière avec le support.

De préférence, la structure de maintien comporte un trou de passage central de la partie proximale de l'âme ou de l'arbre du moteur rotatif pour permettre la fixation de la partie proximale de l'âme à l'arbre du moteur rotatif.

En variante, la structure de maintien est fixe par rapport à l'âme de la brosse, notamment montée sur l'âme de la brosse par son centre ou d'un seul tenant avec cette dernière.

La structure de maintien peut comporter une surface de maintien de la brosse en regard des éléments flexibles. De préférence, la surface de maintien est accolée à la brosse, notamment la partie de brossage de la brosse.

La structure de maintien peut être en contact avec au moins un élément flexible, notamment l'élément flexible le plus éloigné de l'extrémité distale de la brosse.

De préférence, la surface de maintien est plane de contour circulaire.

De préférence, la surface de maintien est perpendiculaire au support.

De préférence, le diamètre de la structure de maintien est supérieur ou égal à 80%, mieux à 90%, encore mieux 95%, du diamètre intérieur du tube quartz. De préférence, la structure de maintien présente un diamètre tel qu'elle ne touche pas la paroi interne du tube lors du nettoyage.

De préférence, la structure de maintien présente un diamètre inférieur au diamètre intérieur du tube quartz, ceci afin de limiter le contact de la structure de maintien avec la paroi interne du tube quartz et ainsi limiter les risques de casse du tube quartz.

La structure de maintien peut comporter une barre de renfort entre le support et la surface de maintien formant un angle non nul et non perpendiculaire avec le support et la surface de maintien.

De préférence, le système d'aspiration comporte un tube d'aspiration configuré pour s'étendre au moins partiellement dans le tube quartz durant le nettoyage du four.

Le tube d'aspiration peut s'étendre le long du support.

En variante, le support est creux sur sa longueur et forme le tube d'aspiration.

Le tube d'aspiration peut comporter une ouverture distale d'aspiration et/ou une pluralité de trous d'aspiration latéraux le long du tube. De préférence, le tube d'aspiration présente une unique ouverture distale.

La structure de maintien de la brosse, notamment la surface de maintien, comporte une ouverture ou encoche dans laquelle l'extrémité distale du tube d'aspiration s'étend.

De préférence, le four LPCVD à nettoyer est horizontal et le tube d'aspiration s'étend dans la moitié basse du four durant le nettoyage.

Le dispositif peut comporter un chariot de déplacement linéaire du dispositif dans le four LPCVD. Le chariot peut être déplacé manuellement ou automatiquement. Le chariot de déplacement du dispositif dans le four LPCVD peut avantageusement être un chariot de déplacement des nacelles de traitement pour les mettre en position dans le four LPCVD.

De préférence, le moteur est fixé au support et la brosse, notamment la partie proximale de l'âme, est fixée à l'arbre du moteur, notamment logée dans un logement de ce dernier. De préférence, le support est identique à une nacelle de four LPCVD. Le tube d'aspiration peut être fixé au support du côté opposé au moteur fixé sur le support.

En variante, le moteur est agencé à l'extrémité proximale du dispositif, notamment du support. L'arbre du moteur peut être fixé au support et la brosse peut être montée sur le support. La partie d'extrémité proximale de l'âme peut être reçue au moins partiellement dans un logement du support, notamment à son extrémité distale configurée pour être reçue dans le tube quartz. Le support peut se présenter sous la forme d'une vis sans fin mobile en rotation. La brosse peut comporter une âme sous forme d'écrou monté sur la vis sans fin. Le dispositif peut comporter un guide de l'âme de la brosse en translation le long du support. Le support et l'âme de la brosse sont alors configuré pour que la brosse soit mobile en translation sur le support lorsque le support est entraîné en rotation par le moteur. Le guide de l'âme peut être hélicoïdal avec un pas supérieur au pas du filetage du support pour que la brosse soit entraînée en translation et rotation autour du support.

L'invention répond également à ce besoin à l'aide d'un ensemble d'un four LPCVD comportant un tube quartz et du dispositif de nettoyage du tube quartz tel que décrit précédemment.

Le four LPCVD peut comporter une cavité recevant le tube quartz, le tube quartz formant l'enceinte de traitement du four.

Le four LPCVD peut comporter des cannes amovibles d'injection des gaz dans l'enceinte.

Le four LPCVD peut comporter une ou plusieurs nacelles amovibles de support sur lesquelles les objets à traiter sont posés.

Le four LPCVD peut comporter un flasque d'extrémité amovible pour fermer l'enceinte de traitement durant le traitement.

Le four LPCVD peut comporter un système de nacelles présentant un flasque de fermeture de l'enceinte à une de ses extrémités.

Le four LPCVD peut comporter une sortie de pompage à son extrémité opposée à l'ouverture de l'enceinte. La sortie de pompage peut comporter un détecteur de poussières et/ou particules. Un tel détecteur permet de déceler la présence de particules se décollant des parois du tube quartz aspirées dans la sortie de pompage, ce qui permet d'en déduire la nécessité d'un nettoyage du tube quartz.

L'invention a également trait à un procédé de nettoyage du tube quartz d'un four LPCVD à l'aide du dispositif de nettoyage tel que décrit précédemment, le procédé comportant :
- l'insertion du dispositif de nettoyage par son extrémité distale dans l'enceinte de traitement du four LPCVD vide formée par le tube quartz,
- le déplacement relatif de la brosse du dispositif de nettoyage par rapport à l'enceinte du four LPCVD contenant le tube quartz.

Par « enceinte de traitement vide », on comprend qu'elle est dépourvue de tout élément amovible, notamment de la ou des nacelles et des cannes à injection du gaz.

Le déplacement peut être un mouvement de translation et/ou un mouvement de rotation.

Le mouvement de translation peut être obtenu par un mouvement répétitif manuel ou automatique, notamment à l'aide du chariot de déplacement linéaire, du dispositif alternativement vers l'ouverture du four et le fond du four.

Le mouvement de rotation peut être obtenu par rotation du moteur rotatif.

### Brève description des dessins

L'invention pourra être mieux comprise à la lecture de la description détaillée qui va suivre, d'exemples de mise en œuvre non limitatifs de celle-ci, et à l'examen des dessins annexés, sur lequel :
[Fig 1] représente schématiquement un four LPCVD en configuration de traitement,
[Fig 2] représente schématiquement l'enceinte de traitement du four LPCVD vide,
[Fig 3] représente schématiquement un ensemble d'un dispositif de nettoyage du tube quartz du four LPCVD de la figure 2 et du four LPCVD de la figure 2,
[Fig 4] représente la brosse de la figure 3 en vue de face,
[Fig 5] représente une alternative de brosse en vue de face, et
[Fig 6] représente schématiquement une variante d'un ensemble d'un dispositif de nettoyage du tube quartz du four LPCVD de la figure 2 et du four LPCVD de la figure 2.

### Description détaillée

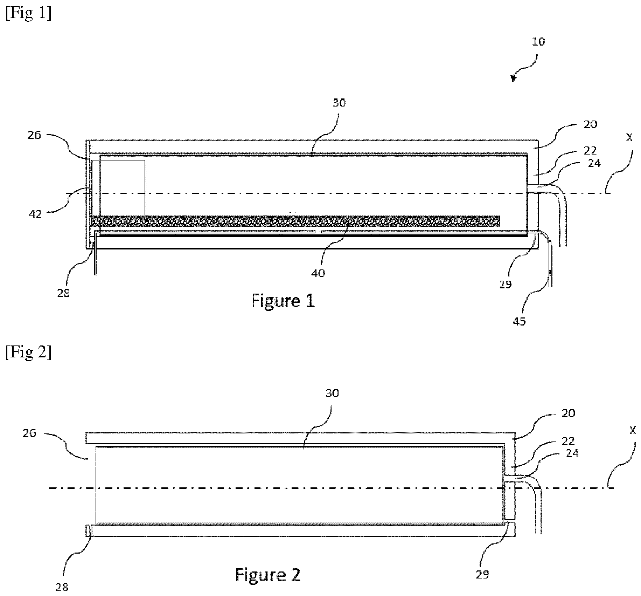

On a illustré sur les figures 1 et 2 un four LPCVD 10 comportant un corps de four 20 cylindrique présentant une extrémité fermée par une paroi de fond 22 comportant une ouverture de pompage 24 et une extrémité ouverte 26. Le corps 20 reçoit un tube quartz 30 s'étendant selon un axe longitudinal X et formant une enceinte de traitement. Le corps 20 et le tube quartz 30 présentent deux trous 28 et 29 de passage des canaux d'injection de gaz. De préférence, le tube quartz fait plus de 1 m, mieux plus de 1,5 m, par exemple sensiblement égal à 2 m. La configuration des différents éléments amovibles dans le four LPCVD peut être tout autre que celle représenté.

Lors de l'utilisation du four 10, comme cela est illustré en figure 1, le four 10 reçoit une ou plusieurs nacelles de traitement 40 montés sur un flasque 42 qui vient fermer l'extrémité ouverte 26. Les nacelles 40 porte les objets à traiter. Des canaux d'injection de gaz 45 sont introduits dans les trous 28 et 29.

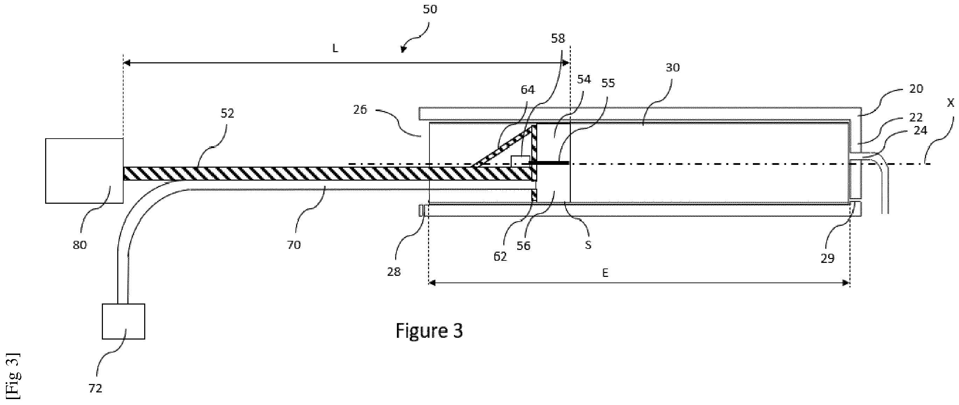

Après plusieurs utilisations, le tube quartz 30 doit être nettoyé pour enlever les dépôts silicium qui se sont formés à sa surface. Il est illustré à la figure 3 un dispositif de nettoyage 50 permettant le nettoyage du tube quartz 30 sans extraire ce dernier du corps de four 20.

Le dispositif de nettoyage 50 est allongé le long d'un axe longitudinal. Il comporte un support 52 relié à une brosse 54 à son extrémité distale destinée à s'insérer dans le four par l'extrémité ouverte 26. L'ensemble du support et de la brosse s'étend préférentiellement sur une longueur L supérieure ou égale à la longueur E du tube quartz.

La brosse 54 comporte une âme 55 et des éléments flexibles 56 s'étendant de l'âme 55 et présentant une longueur supérieure au rayon du tube quartz 30. De préférence, la longueur des éléments flexibles est inférieure ou égale à 105 % du rayon du tube quartz.

L'âme 55 de la brosse s'étend sensiblement selon l'axe longitudinal X du tube quartz 30. L'âme 55 présente une partie dépourvue d'élément flexible permettant sa fixation à l'arbre d'un moteur rotatif 58 fixée par son corps au support. L'âme 55 est fixée à l'arbre du moteur rotatif 58 au travers d'une plaque 62 d'une structure de maintien de la brosse.

L'âme 55 peut être formée de deux brins métalliques torsadées entre eux entre lesquelles les éléments flexibles s'étendent. En variante, l'âme peut être moulée et les éléments flexibles 56 peuvent s'étendre de l'âme, notamment être rapportés lors de l'étape de moulage de l'âme ou être moulés avec l'âme.

Les éléments flexibles 56 peuvent être en téflon ou plastique. Ils peuvent être sous forme de bandes de section rectangulaire ou sous forme de fils cylindriques. De préférence, les éléments flexibles 56 sont sous forme de bandes de largeur comprise entre 3 mm et 5 mm et/ou d'épaisseur comprise entre 3 mm et 5 mm.

La partie de la brosse de laquelle les éléments flexibles s'étend présente une longueur inférieure ou égale à 30% de la longueur E du tube du four. Elle peut être comprise entre 3 cm et 30 cm.

La plaque 62 est cylindrique et présente un diamètre inférieur au diamètre du tube quartz 30. Elle est de préférence accolée à la partie de la brosse présentant les éléments flexibles 56. Elle empêche les éléments flexibles de se plier vers l'arrière lors de l'insertion de la brosse dans le tube quartz afin qu'il puisse frotter efficacement contre la paroi intérieure du tube quartz. La plaque 62 peut être renforcée, comme cela est illustré, par une barre oblique 64 s'étendant entre le support 52 et la périphérie de la plaque 62.

Le dispositif comporte également un système d'aspiration comportant un tube d'aspiration 70 fixé sous le support 52 relié à un dispositif de pompage 72. Le tube d'aspiration 70 s'étend sous le support 52 jusqu'à une ouverture 65 dans la plaque 62.

L'extrémité proximale du support 52 peut être relié à un chariot de déplacement linéaire 80 permettant le déplacement manuel ou automatique en translation de la brosse par l'intermédiaire du support le long de l'axe longitudinal X.

Lors du nettoyage du tube quartz, le moteur rotatif 58 et l'aspiration sont mis en marche et la brosse est insérée dans le tube quartz à l'aide du chariot de déplacement linéaire 80 le long de l'axe X. Le moteur rotatif 58 permet d'entrainer la brosse en rotation dans le tube. Ainsi, les éléments flexibles frottent contre la paroi intérieure du tube quartz de par leur déplacement le long de l'axe X et leur rotation autour de ce même axe, ce qui décolle les particules de dépôt de la paroi interne du tube. Les particules tombent par gravité et sont aspirées par le tube d'aspiration vers l'extérieur.

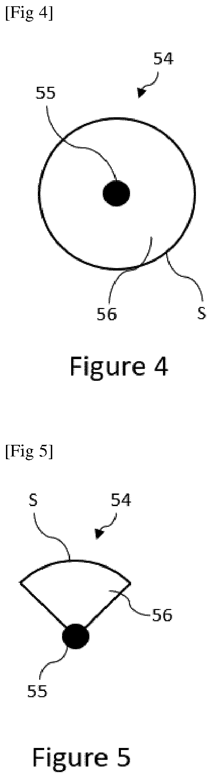

Dans l'exemple illustré sur les figures 3 et 4, la brosse 54 est de surface enveloppe S sensiblement cylindrique et de diamètre supérieure au diamètre du tube quartz 30. Comme cela est illustré sur la figure 5, en variante, les éléments flexibles pourraient ne s'étendre que sur une portion circonférentielle de l'âme. Ceci est rendu possible du fait de la rotation de la brosse qui permet un frottement de toute la circonférence interne du tube quartz.

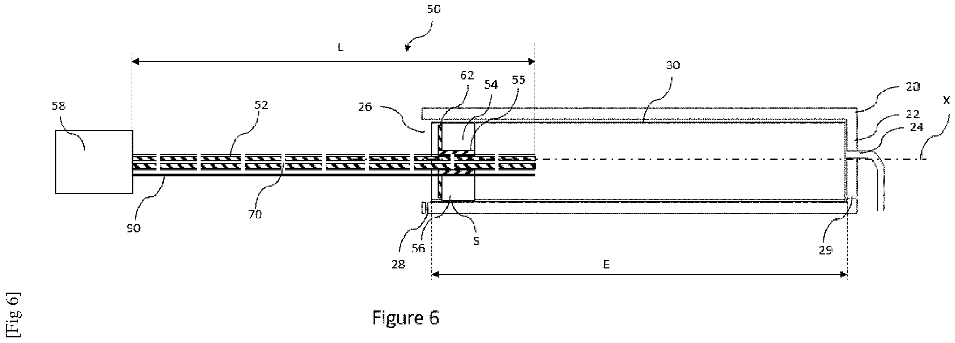

Dans la variante illustrée sur la figure 6, le moteur rotatif 58 est fixée au support 52 se présentant sous la forme d'une tige creuse filetée. La tige creuse a la forme d'une vis sans fin. La brosse 54 comporte une âme 55 creuse sous forme d'écrou montée sur la tige creuse, des éléments flexibles 56 s'étendant de l'âme 55 et une plaque de maintien 62 de la brosse s'étendant de l'âme en arrière des éléments flexibles 56. La plaque 62 peut être venus de matière avec l'âme ou rapportée sur cette dernière. L'âme 55 est guidé en translation par un guide 90 s'étendant le long de la tige. Le guide 90 permet de guider la brosse en translation et/ou rotation le long de la tige lors de la rotation de cette dernière par le moteur rotatif 58. Le guidage peut être obtenu par un ou plusieurs reliefs de l'âme complémentaires du guide ou par un trou dans la plaque 62 permettant le passage du guide 90. Le guide 90 peut être rectiligne de sorte à guider l'âme uniquement en translation le long de la tige lors de la rotation de la tige. En variante non illustré, le guide 90 peut être hélicoïdal avec un pas supérieur au pas du filetage de la tige pour que la brosse soit entraînée en translation et rotation autour de la tige lors de la rotation de cette dernière.

Dans cet exemple, le tube d'aspiration 70 est formé par la tige creuse formant le support 52. Cette dernière peut comporter comme illustré des ouvertures sur sa longueur permettant l'aspiration des particules dans la partie creuse de la tige sur toute sa longueur.

Lors du nettoyage, la tige creuse 52 est insérée dans le four LPCVD par l'extrémité ouverte 26 tout en étant entraînée en rotation par le moteur rotatif 58. La rotation de la tige 52 entraîne la translation de la brosse 54 le long du guide 80. La brosse décolle alors les particules des parois qui sont aspirés par les trous le long de la tige 52.

L'invention n'est pas limitée aux exemples qui viennent d'être décrit. Les différents éléments des modes de réalisations décrits ci-dessus peuvent être combinés entre eux sous réserve de leur compatibilité.

Par exemple, le système d'aspiration du mode de réalisation de la figure 4 peut être remplacé par un creux dans le support. La tige du mode de réalisation de la figure 6 peut être pleine et le dispositif peut comporter un tuyau d'aspiration le long du guide.

L'aspiration peut se faire en extrémité du support ou tout le long de ce dernier.

Le four est représenté horizontal sur les figures ci-dessus. Cependant, il pourrait très bien être vertical.

## Revendications

1. Dispositif de nettoyage (50) du tube quartz (30) d'un four LPCVD (10) comportant :
- un support (52),
- une brosse (54) montée sur le support (52) comportant :
o une âme (55),
o une pluralité d'éléments flexibles (56) de nettoyage s'étendant de l'âme (55) et de longueur, prise d'un axe longitudinal de l'âme (55) à leur extrémité distale, supérieure ou égale au rayon interne du tube quartz (30) du four LPCVD, et
- un système d'aspiration (70) configuré pour aspirer vers l'extérieur du tube quartz des particules détachées de la paroi du tube quartz par la brosse durant le nettoyage, **caractérisé en ce que** le dispositif comporte une structure de maintien (62) de la brosse en amont des éléments flexibles (56), la structure de maintien (62) comportant une surface de maintien de la brosse en regard des éléments flexibles accolée à une partie de brossage de la brosse présentant les éléments flexibles (56).

2. Dispositif selon la revendication 1, dans lequel la longueur des éléments flexibles, prise d'un axe longitudinal de l'âme (55) à leur extrémité distale, est inférieure ou égale à 130%, de préférence inférieure ou égale à 105%, du rayon interne du tube quartz.

3. Dispositif selon la revendication 1 ou 2, dans lequel la brosse (54) présente une surface enveloppe (S) cylindrique de révolution.

4. Dispositif selon l'une quelconque des revendications précédentes, dans lequel l'âme (55) comporte deux brins torsadés, les éléments flexibles (56) s'étendant entre les deux brins.

5. Dispositif selon l'une quelconque des revendications précédentes, dans lequel la brosse (54) est montée mobile en translation et/ou en rotation relativement au support (52).

6. Dispositif selon l'une quelconque des revendications précédentes, comportant un moteur rotatif (58) relié à la brosse (54) et/ou au support (52) pour entrainer la brosse et/ou le support en rotation.

7. Dispositif selon l'une quelconque des revendications précédentes, dans lequel la structure de maintien (62) de la brosse est entre le moteur rotatif (58) et les éléments flexibles (56).

8. Dispositif selon la revendication 7 ou 8, dans lequel la structure de maintien (62) présente un diamètre inférieur au diamètre intérieur du tube quartz, le diamètre de la structure de maintien (62) étant notamment supérieur ou égal à 80%, mieux à 90%, encore mieux 95%, du diamètre intérieur du tube quartz.

9. Dispositif selon l'une quelconque des revendications précédentes, dans lequel le système d'aspiration (70) comporte un tube d'aspiration configuré pour s'étendre au moins partiellement dans le tube quartz durant le nettoyage du four, notamment le tube d'aspiration s'étendant le long du support (52) ou le support (52) étant creux sur sa longueur et formant le tube d'aspiration.

10. Dispositif selon l'une quelconque des revendications précédentes, dans lequel le moteur rotatif (58) est fixé au support (52) et la brosse (54), notamment la partie proximale de l'âme, est fixée à l'arbre du moteur rotatif (58), notamment logée dans un logement de ce dernier.

11. Dispositif selon l'une quelconque des revendications précédentes, dans lequel le moteur rotatif (58) est agencé à l'extrémité proximale du dispositif (10), notamment du support (52), l'arbre du moteur étant fixé au support (52) et la brosse (54) étant montée sur le support (52).

12. Dispositif selon la revendication précédente, dans lequel le support (52) se présente sous la forme d'une vis sans fin mobile en rotation et l'âme de la brosse (55) est sous forme d'écrou monté sur la vis sans fin, le dispositif comportant un guide (90) de l'âme de la brosse (55) en translation le long du support (52).

13. Ensemble d'un four LPCVD comportant un tube quartz (30) et du dispositif selon l'une quelconque des revendications précédentes.

14. Procédé de nettoyage du tube quartz (30) d'un four LPCVD à l'aide du dispositif de nettoyage selon l'une quelconque des revendications 1 à 13, le procédé comportant :
- l'insertion du dispositif de nettoyage (50) par son extrémité distale dans l'enceinte de traitement du four LPCVD vide formée par le tube quartz (30),
- le déplacement relatif de la brosse (54) du dispositif de nettoyage par rapport à l'enceinte du four LPCVD contenant le tube quartz.
